# EUROPÄISCHE PATENTSCHRIFT

(11) **EP 0 607 595 B1**
(45) Veröffentlichungstag und Bekanntmachung des Hinweises auf die Patenterteilung: **20.02.2002**
(21) Anmeldenummer: 93120568.6
(22) Anmeldetag: 21.12.1993
(51) Int. Cl.: G01R 33/06, G01R 33/022, G01R 15/20

(54) **Sensorchip**
Sensor chip
Capteur en puce

(30) Priorität: 13.01.1993 DE 4300605
(43) Veröffentlichungstag der Anmeldung: 27.07.1994
(73) Patentinhaber: LUST ELECTRONIC-SYSTEME GmbH, D-35633 Lahnau-Waldgirmes (DE)
(72) Erfinder: Dettmann, Fritz, D-35764 Sinn-Edingen (DE); Loreit, Uwe, D-35580 Wetzlar-Nauborn (DE)
(74) Vertreter: Missling, Arne, Dipl.-Ing.

(56) Entgegenhaltungen:
- DD-A- 155 220
- DE-A- 3 131 431
- DE-C- 4 212 737
- US-A- 3 820 089
- SENSORS AND ACTUATORS A, Bd. 37-38, Juni 1993 LAUSANNE CH, Seiten 461-465, W.ANDRÄ ET AL. 'Current measurements based on thin-film magnetoresistive sensors' & PROCEEDINGS OF EUROSENSORS VI, 5.Oktober 1992 - 7.Oktober 1992
- SENSORS AND ACTUATORS A, Bd. 27, Nr. 1-3, Mai 1991 LAUSANNE CH, Seiten 763-766, F.ROTTMANN ET AL. 'New Magnetoresistive Sensors: Engineering and Applications'
- PATENT ABSTRACTS OF JAPAN vol. 9 no. 8 (E-289) ,12.Januar 1985 & JP-A-59 158575 (HITACHI) 8.September 1984,
- ELECTRONIQUE RADIO PLANS, Nr. 510, Mai 1990 PARIS FR, Seiten 19-26, D.PARET 'Les capteurs magnétiques'
- NEC RESEARCH AND DEVELOPMENT, Nr. 93, April 1989 TOKYO JP, Seiten 11-15, H.KONNO ET AL. 'A Monolithic Superminiature Magnetoresistive Sensor'
- ELEKTRONIK, Bd. 42, Nr. 20, Oktober 1993 MUNCHEN DE, Seiten 42-44, J.RÜHL ET AL. 'Stromsensor als Mikrosystem'

## Beschreibung

Die Erfindung betrifft einen Sensorchip mit einer Brückenschaltung in form einer Wheatstone-Brücke zur Messung von Gradienten der magnetischen Feldstärke, bestehend aus vier magnetoresistiven Widerständen, die parallel und in zwei Bereichen mit Abstand zu einer Mittelachse angeordnet sind, von denen je zwei in Reihe geschaltete Widerstände jeweils einen Brückenzweig zwischen kontakten für eine Betriebsspannung der Wheatstone-Brücke bilden, wobei jeder Bereich jeweils einen magnetoresistiven Widerstand des einen Brückenzweiges und denjenigen magnetoresistiven Widerstand des jeweils an deren Brückenzweiges umfasst, der ihm in der in Form einer Wheatstone - Brücke ausgeführten Brückenschaltung gegenüberliegt.

Ein derartiger Sensorchip ist aus der DE-C1 42 12 737 bekannt, die nach dem Prioritätstag veröffentlicht wurde.

Meßanordnungen zur Bestimmung von Magnetfeldgradienten dienen insbesondere zur potentialfreien Messung der Stromstärke eines elektrischen Stromes, der ein derartiges Magnetfeld hervorruft. Da die gesamte Umgebung eines auf diese Weise zu bestimmenden Magnetfeldes stets schon mit großräumigen Störmagnetfeldern behaftet ist, liegt es nahe, mit Hilfe von Magnetfeldgradienten zwischen dem auszumessenden und einem Störmagnetfeld zu unterscheiden.

Solche Anordnungen sind aus den DD-Patentschriften 155 220 und 275 745 bereits bekannt. Dabei werden magnetoresistive Sensorelemente eingesetzt, da deren Empfindlichkeit groß genug ist, um Ströme über einen großen Meßbereich nachzuweisen. Der Linearitätsbereich derartiger Sensorelemente ist allerdings begrenzt. Ihre an und für sich hohe Empfindlichkeit ist stark von der Temperatur und von einem an den Sensorelementen anzubringenden Hilfsmagnetfeld abhängig. Die Empfindlichkeit der einzelnen Sensorelemente ist darüber hinaus sehr unterschiedlich.

Die Erfindung hat sich deshalb die Aufgabe gestellt, diese Nachteile zu vermeiden und einen Sensorchip der eingangs näher bezeichneten Art so auszuführen, daß das Ausgangssignal einem auszumessenden elektrischen Strom proportional ist, daß seine Empfindlichkeit weder temperatur- noch hilfsmagnetfeldabhängig ist und stets eine etwa gleiche Empfindlichkeit aufweist.

Erfindungsgemäß wird die Aufgabe mit den Merkmalen des Anspruches 1 gelöst.

Die Erfindung löst die Aufgabenstellung in überraschend einfacher Weise. Das Ausgangssignal des Sensorchips hat einen unbegrenzten Linearitätsbereich und ist weder temperatur- noch hilfsmagnetfeldabhängig. Die Exemplarstreuung ist äußerst gering, da die Topographie des Sensorchips mit Hilfe der Mikrostrukturierung sehr präzise gefertigt werden kann.

Da der Abstand der beiden Bereiche, das heißt die Basislänge des Gradiometers, klein gehalten werden kann, ist auch die Beeinflussung durch Störmagnetfelder unerheblich, deren Quellen einen von der Meßanordnung dagegen großen Abstand haben.

Eine Anordnung mit einem erfindungsgemäßen Sensorchip besitzt einen hohen Grad an geometrischer Symmetrie als Voraussetzung für eine symmetrische Erwärmung des Sensorchips im Betrieb. Von der Symmetrie ausgenommen ist lediglich der Winkel der Barberpolstrukturen auf den magnetoresistiven Schichtstreifen. Durch die betriebsstromverursachte symmetrische Temperaturerhöhung wird in allen Schichtstreifen der Wheatstone-Brücke eine gleiche Drehung der Magnetisierung und infolgedessen eine gleiche Widerstandsänderung hervorgerufen. Damit ist, über die eigentliche Aufgabenstellung der Erfindung hinaus, auch die temperaturabhängige Nullpunktdrift in dem Sensorchip weitgehend beseitigt.

Die Erfindung wird nachstehend anhand der Zeichnung an einem Ausführungsbeispiel näher erläutert. Es zeigen
- Fig. 1: eine Wheatstone-Brücke nach dem Stand der Technik,
- Fig. 2: einen Sensorchip gemäß der Erfindung,
- Fig. 3: die Verbindung eines erfindungsgemäßen Sensorchips mit einer Stromleitung zur Messung des in dieser fließenden Stromes und
- Fig. 4: die Ausbildung der Anschlußkontakte und der Stromführung bei einer Anordnung entsprechend Fig. 3.

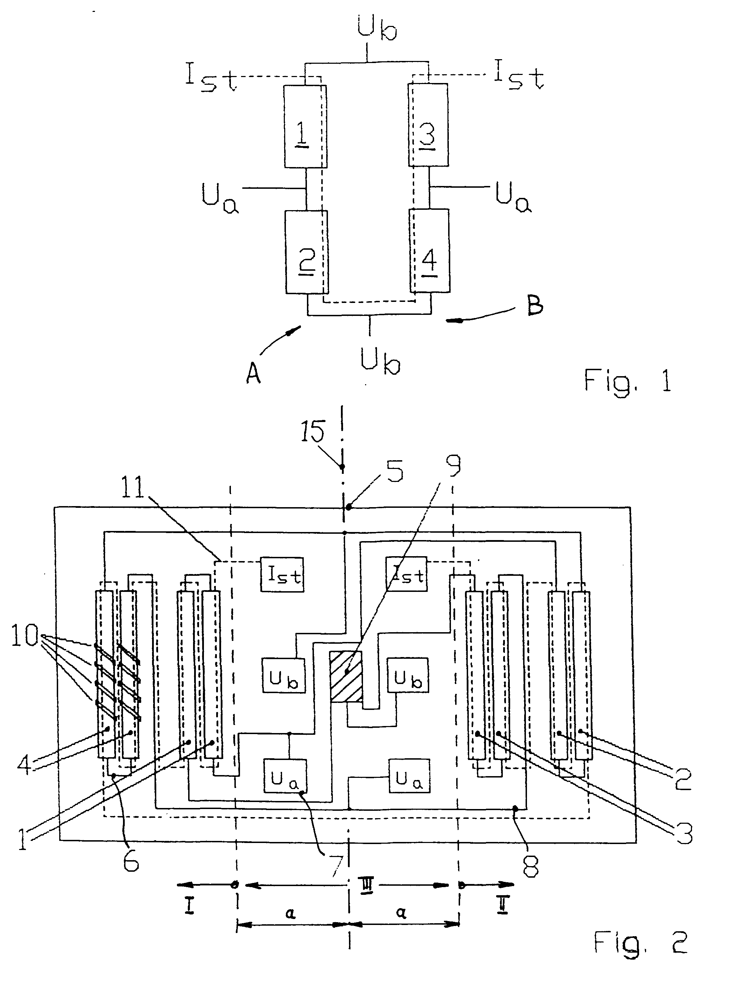

In Fig. 1 ist eine Brückenschaltung in Form einer Wheatstone-Brücke gezeigt, bei der zwei magnetoresistive Widerstände 1 und 2 in einem ersten Brückenzweig A und zwei weitere magnetoresistive Widerstände 3 und 4 in einem zweiten Brückenzweig B, jeweils in Reihe geschaltet, angeordnet sind. Die Wheatstone-Brücke wird mit einer Betriebsspannung U_{b} versorgt, als Ausgangssignal dient die Ausgangsspannung Uₐ. Unter mindestens einem der Widerstände 1 bis 4 ist ein gegen diesen isolierter Dünnschicht-Streifenleiter vorgesehen; um gleiche Bauteile zu erhalten, ist es naheliegend, daß unter jedem der Widerstände 1 bis 4 ein Dünnschicht-Streifenleiter vorgesehen ist. Die Dünnschicht-Streifenleiter, die in der Zeichnung weggelassen sind, weil ihre Anordnung dem Fachmann geläufig ist, werden von dem Steuerstrom Iₛₜ durchflossen. Eine derartige Anordnung entspricht dem Stand der Technik.

Die Einzelheiten des erfindungsgemäßen Sensorchips sind in der Darstellung der Fig. 2 zu erkennen. Der Sensorchip 5 umfaßt zwei Bereiche I und II, die gleich weit mit dem Abstand a von einer Mittelachse 15 beginnend jeweils zwei magnetoresistive Widerstände 1;4 und 2;3 umfassen. Die Widerstände 1 bis 4 bestehen ihrerseits aus jeweils zwei unter sich und zu den übrigen parallelen Schichtstreifen, die in bekannter Weise mit Barberpol-Strukturen 10 versehen sind. Die BarberpolStrukturen 10, die in der Fig. 2 nur für den Widerstand 4 gezeigt sind, sind bei allen Widerständen 1 bis 4 gleich. Dadurch ist dafür gesorgt, daß nur ein anliegender Feldgradient die Brücke aussteuert. Nach wie vor befinden sich die Widerstände 1 und 2 und die Widerstände 3 und 4 jeweils auf ein und demselben Brückenzweig A;B; jedoch sind in den Bereichen I und II jeweils zwei Widerstände 1;4 und 2;3 aus verschiedenen Brückenzweigen A;B räumlich zusammengefaßt. Dies wird auch durch die eingezeichneten elektrischen Leitungen 6 zwischen den Schichtstreifen und den von den Schichtstreifen nach außen führenden Leitungen 8 deutlich. Die Leitungen 8 verbinden Flächenstücke 7 mit den Schichtstreifen. Die Flächenstücke 7 bilden, in einer Ebene gelegen, aus dem Sensorchip 5 herausführende Kontakte für die Betriebsspannung U_{b} und die Ausgangsspannung Uₐ. Zwei weitere Flächenstücke 7 dienen als Außenkontakte für die Zuführung des Steuerstromes Iₛₜ. Die Flächenstücke 7 sind im zentralen Bereich III des Sensorchips 5 symmetrisch zur Mittelachse 15 angeordnet.

Im Bereich dieser Mittelachse 15 befindet sich weiterhin ein änderbarer Widerstand 9, der in der dargestellten Weise mit den Zweigen der Wheatstone-Brücke in Reihe geschaltet ist. Der Widerstand 9 kann mechanisch oder mittels Laser abgetragen werden, wobei diese Abtragung so erfolgt, daß die Symmetrie der Gesamtanordnung erhalten wird.

Die Ausgangsspannung Uₐ wird einem nicht gezeichneten Verstärker zugeführt. Dessen Ausgang, der Steuerstrom Iₛₜ, wird so eingestellt, daß die Wirkung des äußeren Magnetfeldgradienten am Ort der Schichtstreifen aufgehoben ist. Der Steuerstrom Iₛₜ bildet das Ausgangssignal der Anordnung. Er ist dem Magnetfeldgradienten direkt proportional und ist nicht von der Temperatur und von großräumigen Störmagnetfeldern abhängig. Durch die erfindungsgemäße Anordnung der weitgehenden Achssymmetrie am Sensorchip 5 ist dafür gesorgt, daß die auftretende Erwärmung in Symmetrie zur Mittelachse 15 erfolgt. Die durch Magnetostriktion bewirkten Widerstandsänderungen in den Schichtstreifen sind deshalb überall gleich und bewirken keine Änderung der Ausgangsspannung Uₐ. Eine Nullpunktdrift in Abhängigkeit der Temperatur ist damit weitgehend unterdrückt. Auch das Trimmen der Brücke erfolgt in achssymmetrischer Weise, da der Widerstand 9 in der Mittelachse 15 angeordnet ist. Auf diese Weise läßt sich die Ausgangsspannung Uₐ in Richtung Null einstellen, wenn kein Magnetfeldgradient vorhanden ist.

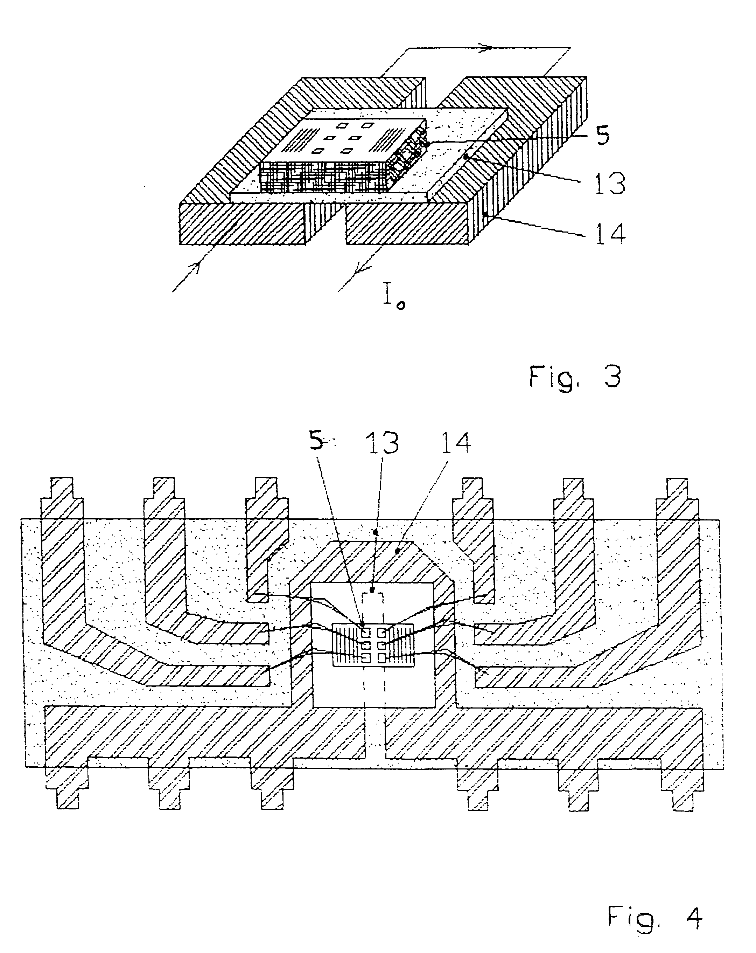

Die Fig. 3 und 4 zeigen die Anwendung eines erfindungsgemäßen Sensorchips 5 bei der Messung der Stromstärke Iₒ eines elektrischen Stromes Iₒ durch eine Leitung 14. Der Sensorchip 5 ist gegen die Leitung 14 durch eine Isolierung 13 elektrisch getrennt. Es sind zwei Leitungen 14 vorgesehen, die vom Strom Iₒ in der in Fig. 3 dargestellten Weise durchflossen werden. Dadurch entsteht ein Magnetfeldgradient, der dem Strom Iₒ in der Leitung 14 proportional ist. Störmagnetfelder, die durch in der Nähe vorbeifließende andere Ströme hervorgerufen sein können, haben auf das Ausgangssignal, den Steuerstrom Iₛₜ, keine Wirkung, da ihr Magnetfeld auf die beiden symmetrischen Bereiche I und II in gleichem Maße einwirkt. Dazu trägt bei, daß die Abstände zwischen den Bereichen I und II kleiner als 1 mm sind.

Die Fig. 4 zeigt ein komplettes Bauelement zur potentialfreien Messung der Stromstärke Io. Beide Leitungen 14 sind hier so geformt, daß wiederum ein Magnetfeldgradient am Ort des Sensorchips 5 entsteht. Die Isolation 13 zwischen dem Sensorchip 5 und der Leitung 14 und die Anordnung der Bauelementepins für den Strom Iₒ und für die Versorgung des Sensorchips 5 auf entgegengesetzten Seiten des Bauelementes sorgen hier für eine hohe Schutzisolationsspannung.

## Patentansprüche

1. Sensorchip mit einer Brückenschaltung in Form einer Wheatstone-Brücke zur Messung von Gradienten der magnetischen Feldstärke, bestehend aus vier magnetoresistiven Widerständen (1 bis 4), die parallel und in zwei Bereichen (I;II) mit Abstand zu einer Mittelachse (15) angeordnet sind, von denen je zwei in Reihe geschaltete Widerstände (1;2 und 3;4) jeweils einen Brückenzweig (A; B) zwischen Kontakten für eine Betriebsspannung (Ub) der Wheatstone-Brücke bilden, wobei die Widerstände (1 bis 4) der beiden Bereiche (I;II) symmetrisch zur Mittelachse (15) und einander gegenüberliegend angeordnet sind, wobei die Widerstände (1 bis 4) aus magnetoresistiven Schichtstreifen bestehen und sich über oder unter mindestens einem Schichtstreifen ein gegen diesen isolierter Dünnschicht-Streifenleiter befindet, durch den ein meßbarer elektrischer Steuerstrom (Iₛₜ) fließen kann, und wobei jeder Bereich (I;II) jeweils einen magnetoresistiven Widerstand (1/2;3/4) des einen Brückenzweiges (A; B) und denjenigen magnetoresistiven Widerstand (4/3;2/1) des jeweils anderen Brückenzweiges (B; A) umfasst, der ihm in der in Form einer Wheatstone - Brücke ausgeführten Brückenschaltung gegenüberliegt.

2. Sensorchip nach Anspruch 1, **dadurch gekennzeichnet, daß** die Widerstände (1 bis 4) der Bereiche (I;II) symmetrisch paarweise gleich ausgebildet sind.

3. Sensorchip nach Anspruch 2, **dadurch gekennzeichnet, daß** die Widerstände (1 bis 4) aus jeweils mindestens zwei Schichtstreifen bestehen.

4. Sensorchip nach einem der Ansprüche 1 oder 3, **dadurch gekennzeichnet, daß** die Schichtstreifen mindestens paarweise mit der gleichen Barberpol-Struktur (10) versehen sind.

5. Sensorchip nach einem der Ansprüche 1 bis 4, **dadurch gekennzeichnet, daß** der Steuerstrom (Iₛₜ) so wählbar ist, daß von der Wheatstone-Brücke gemessene Änderungen der magnetischen Feldstärke kompensiert werden.

6. Sensorchip nach einem der Ansprüche 1 bis 5, **dadurch gekennzeichnet, daß** mehrere Dünnschicht-Streifenleiter vorgesehen sind.

7. Sensorchip nach Anspruch 6, **dadurch gekennzeichnet, daß** über oder unter jedem Schichtstreifen der Widerstände (1 bis 4) ein Dünnschicht-Streifenleiter vorgesehen ist.

8. Sensorchip nach Anspruch 6, **dadurch gekennzeichnet, daß** die Dünnschicht-Streifenleiter symmetrisch zur Mittelachse (15) angeordnet sind.

9. Sensorchip nach einem der Ansprüche 1 bis 8, **dadurch gekennzeichnet, daß** in jedem Brückenzweig ein änderbarer, magnetoresistiver Widerstand (9) mit den Zweigen der Wheatstone-Brücke in Reihe geschaltet ist.

10. Sensorchip nach einem der Ansprüche 1 bis 9, **dadurch gekennzeichnet, daß** auf der Oberfläche des Sensorchips (5) als Flächenstücke (7) ausgeführte Kontakte für die Betriebsspannung (U_{b}) und die Ausgangsspannung (Uₐ) der Wheatstone-Brücke und für den Steuerstrom (Iₛₜ) vorgesehen sind.

11. Sensorchip nach Anspruch 10, **dadurch gekennzeichnet, daß** die Flächenstücke (7) symmetrisch zur Mittelachse (15) angeordnet sind.

12. Sensorchip nach Anspruch 11, **dadurch gekennzeichnet, daß** die Flächenstücke (7) im zentralen Bereich (III) des Sensorchips (5) liegen.

13. Sensorchip nach einem der Ansprüche 1 bis 12, **dadurch gekennzeichnet, daß** die magnetoresistiven Schichtstreifen in einer Ebene angeordnet sind.

14. Sensorchip nach Anspruch 13, **dadurch gekennzeichnet, daß** die zwischen den Schichtstreifen und/oder zwischen diesen und den Flächenstücken (7) erforderlichen elektrischen Leitungen (6;8) in der gleichen Ebene angeordnet sind.

15. Sensorchip nach Anspruch 14, **dadurch gekennzeichnet, daß** jeder änderbare Widerstand (9) symmetrisch zur Mittelachse (15) angeordnet ist.

16. Sensorchip nach Anspruch 15, **dadurch gekennzeichnet, daß** der Widerstand (9) durch mechanische Abtragung änderbar ist.

17. Sensorchip nach einem der Ansprüche 1 bis 16, **dadurch gekennzeichnet, daß** zu messende Ströme in elektrischen Leitungen (14) fließen, die symmetrisch zur Mittelachse (15) angeordnet und zu dieser fixiert sind.

18. Sensorchip nach Anspruch 17, **dadurch gekennzeichnet, daß** die Leitungen (14) in Reihe geschaltet sind.

## Claims

1. A sensor chip with a bridge circuit in the form of a Wheatstone bridge for the measurement of gradients of the magnetic field intensity, comprising four magnetoresistive resistors (1 to 4) arranged in parallel in two regions (I; II) at a distance from a central axis (15), of which two pairs of resistors (1; 2 and 3; 4) connected in series each form a bridge arm (A; B) between contacts for an operating voltage (Ub) of the Wheatstone bridge, wherein the resistors (1 to 4) of the two regions (I; II) are arranged opposite one another symmetrically to the central axis (15), wherein the resistors (1 to 4) comprise magnetoresistive laminated strips, and a thin-layer strip conductor, through which a measurable electric control current (Iₛₜ) can flow, is arranged above or below at least one laminated strip and is insulated therefrom, and wherein each region (I, II) comprises a magnetoresistive resistor (1/2; 3/4) of the one bridge arm (A; B) and that magnetoresistive resistor (4/3; 2/1) of the respective other bridge arm (B; A) which is arranged opposite it in the bridge circuit in the form of a Wheatstone bridge.

2. A sensor chip according to claim 1, **characterised in that** the resistors (1 to 4) of the regions (I; II) are formed identically and symmetrically in pairs.

3. A sensor chip according to claim 2, **characterised in that** the resistors (1 to 4) each comprise at least two laminated strips.

4. A sensor chip according to either one of claims 1 and 3, **characterised in that** the laminated strips are provided at least in pairs with the same barber's pole structure (10).

5. A sensor chip according to any one of claims 1 to 4, **characterised in that** the control current (Iₛₜ) can be selected so that changes in the magnetic field intensity, measured by the Wheatstone bridge, can be compensated for.

6. A sensor chip according to any one of claims 1 to 5, **characterised in that** a plurality of thin-layer strip conductors are provided.

7. A sensor chip according to claim 6, **characterised in that** a thin-layer strip conductor is provided above or below each laminated strip of the resistors (1 to 4).

8. A sensor chip according to claim 6, **characterised in that** the thin-layer strip conductors are arranged symmetrically to the central axis (15).

9. A sensor chip according to any one of claims 1 to 8, **characterised in that**, in each bridge arm, a variable, magnetoresistive resistor (9) is connected in series to the arms of the Wheatstone bridge.

10. A sensor chip according to any one of claims 1 to 9, **characterised in that** contacts, formed as surface elements (7), for the operating voltage (U_{b}) and the output voltage (Uₐ) of the Wheatstone bridge and for the control current (Iₛₜ) are provided on the surface of the sensor chip (5).

11. A sensor chip according to claim 10, **characterised in that** the surface elements (7) are arranged symmetrically to the central axis (15).

12. A sensor chip according to claim 11, **characterised in that** the surface elements (7) lie in the central region (III) of the sensor chip (5).

13. A sensor chip according to any one of claims 1 to 12, **characterised in that** the magnetoresistive laminated strips are arranged in one plane.

14. A sensor chip according to claim 13, **characterised in that** the electric lines (6; 8) required between the laminated strips and/or between the latter and the surface elements (7) are arranged in the same plane.

15. A sensor chip according to claim 14, **characterised in that** each variable resistor (9) is arranged symmetrically to the central axis (15).

16. A sensor chip according to claim 15, **characterised in that** the resistor (9) is variable by mechanical abrasion.

17. A sensor chip according to any one of claims 1 to 16, **characterised in that** the currents to be measured flow in electric lines (14) arranged and fixed symmetrically to the central axis (15).

18. A sensor chip according to claim 17, **characterised in that** the lines (14) are connected in series.

## Revendications

1. Puce électronique pour capteur, avec un branchement en pont, sous la forme d'un pont de Wheatstone, pour la mesure des gradients d'intensité de champ magnétique, constitué de quatre résistances (1 à 4), de nature magnétorésistive et disposées parallèlement et dans deux zones (I, II) sous un espacement par rapport à un axe médian (15), résistances dont chaque fois deux résistances (1; 2 et 3; 4) branchées en série forment chaque fois une branche de pont (A, B) entre les contacts d'une tension de service (Ub) du pont de Wheatstone, les résistances (1 à 4) des deux zones (I, II) étant disposées symétriquement par rapport à l'axe médian (15) et en opposition les unes les autres, les résistances (1 à 4) étant réalisées sous la forme de bandes de couches magnétorésistives, et un conducteur à ruban à couche mince se trouve au-dessus ou au-dessous d'au moins une bande de couche, isolé par rapport à celle-ci, conducteur à ruban à couche mince par lequel peut passer un courant électrique de commande (Iₛₜ) mesurable, et chaque zone (I, II) comprenant respectivement une résistance magnétorésistive (1/2;3/4) d'une branche de pont (A; B) et la résistance magnétorésistive (4/3;3/4) de l'autre branche de pont (B;A), qui lui est opposée, dans le branchement en pont réalisé sous la forme d'un pont de Wheastone.

2. Puce électronique pour capteur selon la revendication 1, **caractérisée en ce que** les résistances (1 à 4) des zones (I;II) sont réalisées à l'identique, par paires, symétriquement.

3. Puce électronique pour capteur selon la revendication 2, **caractérisée en ce que** les résistances (1 à 4) sont constituées chaque fois d'au moins deux bandes de couche.

4. Puce électronique pour capteur selon la revendication 1 ou 3, **caractérisée en ce que** les bandes de couche sont munies, au moins par paires, de la même structure (10).

5. Puce électronique pour capteur selon l'une des revendications 1 à 4, **caractérisée en ce que** le courant de commande (Iₛₜ) est susceptible d'être sélectionné de manière que les que les fluctuations, mesurées par le pont de Wheatstone, de l'intensité du champ magnétique soient compensées.

6. Puce électronique pour capteur selon l'une des revendications 1 à 5, **caractérisée en ce que** plusieurs conducteurs à ruban en couche mince sont prévus.

7. Puce électronique pour capteur selon la revendication 6, **caractérisée en ce qu'**un conducteur à ruban à couche mince est prévu sur ou sous chaque bande de couche des résistances (1 à 4).

8. Puce électronique pour capteur selon la revendication 6, **caractérisée en ce que** les conducteurs à ruban à couche mince sont disposés symétriquement par rapport à l'axe médian (15).

9. Puce électronique pour capteur selon l'une des revendications 1 à 8, **caractérisée en ce que**, dans chaque branche du pont, une résistance magnétorésistive (9), de valeur modifiable, est branchée en série avec les branches du pont de Wheastone.

10. Puce électronique pour capteur selon l'une des revendications 1 à 9, **caractérisée en ce que**, sur la surface de la puce électronique de capteur (5), sont prévus des contacts, réalisés sous la forme d'éléments de surface (7), pour la tension de service (U_{b}) et la tension de sortie (Uₐ) du pont de Wheatstone et pour le courant de commande (Iₛₜ).

11. Puce électronique pour capteur selon la revendication 10, **caractérisée en ce que en ce que** les éléments de surface (7) sont disposés symétriquement par rapport à l'axe médian (15).

12. Puce électronique pour capteur selon la revendication 11, **caractérisée en ce que** les éléments de surface (7) sont placés dans la zone centrale (III) de la puce électronique pour capteur (5).

13. Puce électronique pour capteur selon l'une des revendications 1 à 12, **caractérisée en ce que** les bandes de couches magnétorésistives sont disposées dans un plan.

14. Puce électronique pour capteur selon la revendication 13, **caractérisée en ce que** les lignes électriques (6; 8), nécessaires entre les bandes de couches et/ou entre celles-ci et les éléments de surface (7), sont disposées dans le même plan.

15. Puce électronique pour capteur selon la revendication 14, **caractérisée en ce que** que chaque résistance (9) variable est disposée symétriquement par rapport à l'axe médian (15).

16. Puce électronique pour capteur selon la revendication 15, **caractérisée en ce que** la valeur de la résistance (9) est modifiable, par usinage mécanique avec enlèvement de matière.

17. Puce électronique pour capteur selon l'une des revendications 1 à 16, **caractérisée en ce que** les courants à mesurer passent dans des lignes électriques (14), disposées symétriquement par rapport à l'axe médian (15) et fixées par rapport à celui-ci.

18. Puce électronique pour capteur selon la revendication 17, **caractérisée en ce que** les lignes (14) sont branchées en série.
